(19) Europäisches Patentamt
European Patent Office
Office européen des brevets

(11) EP 1 640 428 A1

(12) **EUROPEAN PATENT APPLICATION**
published in accordance with Art. 158(3) EPC

(43) Date of publication:
**29.03.2006 Bulletin 2006/13**

(21) Application number: **04746707.1**

(22) Date of filing: **23.06.2004**

(51) Int Cl.:
***C09J 163/00*** *(1990.01)* ***C09J 7/00*** *(1968.09)*
***B32B 15/08*** *(1968.09)*

(86) International application number:
**PCT/JP2004/009238**

(87) International publication number:
**WO 2004/113466 (29.12.2004 Gazette 2004/53)**

(84) Designated Contracting States:
**AT BE BG CH CY CZ DE DK EE ES FI FR GB GR HU IE IT LI LU MC NL PL PT RO SE SI SK TR**

(30) Priority: **23.06.2003 JP 2003177805**
**01.08.2003 JP 2003205358**

(71) Applicant: **TORAY INDUSTRIES, INC.**
**Tokyo 103-8666 (JP)**

(72) Inventors:
- **YAMAMOTO, Tetsuya**
**5200842 (JP)**
- **KITAMURA, Tomohiro**
**5202135 (JP)**
- **SUZUKI, Sachio**
**5200842 (JP)**

(74) Representative: **Schaeberle, Steffen**
**Hoefer & Partner**
**Patentanwälte**
**Gabriel-Max-Strasse 29**
**D-81545 München (DE)**

(54) **ADHESIVE COMPOSITION FOR SEMICONDUCTOR DEVICE AND COVER LAY FILM, ADHESIVE SHEET, AND COPPER-CLAD POLYIMIDE FILM EACH MADE WITH THE SAME**

(57) An adhesive composition for semiconductor devices which comprises an epoxy resin, a phenoxy resin, and a hardener, wherein part or all of the epoxy resin comprises at least one type of epoxy resin selected from the followings:

(a) a dimer acid modified epoxy resin
(b) a phosphorus containing epoxy resin having an epoxy equivalent of 2000 to 6000.

Said adhesive composition has satisfactory flexural properties even in a high-temperature environment while retaining an excellent toughness of the adhesive and is excellent in soldering heat resistance, adhesive property, flame retardancy and electrical properties. The adhesive composition can suitable be used for cover lay films, adhesive sheets and copper-clad polyimide films.



Printed by Jouve, 75001 PARIS (FR)

## Description

Field of the invention

This invention relates to an adhesive composition for semiconductor device and cover lay film, adhesive sheet, copper-clad polyimide film made therewith.

Background art

Flexible print wiring board (hereafter referred to as FPC) is made by forming a pattern circuit by lithography, etc. on a copper-clad polyimide film (CCL) which is prepared by providing copper foil on one side or both sides of a base film represented by such as polyimide film or polyethylene terephthalate film through an adhesive layer, and by laminating thereon a cover lay film as a protective layer.

This FPC is, because its thickness is usually not more than 100 micrometers and it has excellent flexibility and good flexural properties, used as various electronic equipments which have been made small and light, for example, a substrate for moving part of hard disk drive (HDD) for personal computer, a pick-up module for CD and DVD drive and a hinge substrate of cellular phone. Moreover, applications to an image recording part of home use VTR, to a data-logging part of a digital camera and to a data-logging part for car navigation is also progressing by further miniaturization of HDD. These requirements for FPC which is used mainly as the moving part, pick-up and hinge part are good adhesive properties between the metal copper foil and the adhesive layer or between the film and the adhesive layer, and to suppress a local distortion on metal copper foil by a moderate modulus of the adhesive, and epoxy type adhesives have conventionally been used in many cases.

However, heat generation in electronic device increases remarkably in recent years accompanied by the improvement of performance of components, elements and CPU in the electronic device, and the mean temperature in the device is also apt to rise, for example, may rise to 80°C or more in a notebook computer or in a vehicle device under continuous use. On the other hand, since said FPC material currently used in these devices has been made in the assumption of being used in room temperature, if operating temperature of the FPC material rises to 50-80°C, the adhesives constituting the FPC material may soften and cause a remarkable decrease of storage modulus, and performances such as flexural property, will fall remarkably by distortion of each layer of FPC.

As a method of solution for such a trouble, there is a high heat resistant and high flexural resistant FPC material by which the softening of the adhesives is suppressed by an adhesive layer having a specific modulus and, thereby, good flexural properties at high temperature can be attained (JP2001-98243A).

On the other hand, because the effect on the environment has become important as a social problem, the fire-resistant regulation required in electric/electronic product is shifting to a higher safety in consideration of safety to human body. That is, the electric/electronic product is required not only not to burn easily, but also to little generate a harmful gas or little emit a smoke.

Conventionally, in glass-epoxy substrates, copper clad laminates, flexible print circuit boards and a molding compounds which carry electronic parts thereon, in view of safeties such as fire prevention and fire retardancy, as flame retarders to be incorporated to these materials, derivatives represented by tetrabromobisphenol A (such as brominated epoxy resins) are widely and generally used, in particular. However, although these brominated epoxy resins (brominated aromatic compounds) have outstanding flame retardancy, they not only generate corrosive bromine and corrosive hydrogen bromide by pyrolysis, but also, when they decompose under existence of oxygen, may generate a highly toxic polybromodibenzofuran and polybromodibenzo dioxin.

For that reason, phosphorus containing epoxy resin has been widely investigated to replace the conventional brominated flame retardant epoxy resin (JP2001-151990A, JP2001-123049A). Since the phosphorus containing epoxy resin is obtained by reacting a phosphorus compound with an epoxy resin, there is no problem that the thermal resistance and bleed property of the FPC material fall like an addition type flame retarder, and the phosphorus containing epoxy resin makes an outstanding flame retardant effect as well as making it possible to provide a flame retardant resin composition which does not contain a halogen and is excellent in thermal resistance as FPC material and in adhesive property. An adhesive sheet for semiconductor devices, cover lay film and flexible print wiring board (JP2003-105167A) etc. made from said flame retardant resin composition are known and they are put in practical use as the FPC material which does not contain a halogen.

Disclosure of the invention

However, when the modulus of the adhesive layer of the composition in room temperature to 100°C was made high, to the composition which has conventionally been investigated, in order to give a good flexural property at high temperature environment, the flexibility of FPC is damaged such that the toughness of the adhesive layer in room

temperature is decreased, that the adhesive strength to the metal copper foil in FPC and soldering heat resistance decrease and that the dimensional stability and the curl of the copper-clad polyimide film (CCL) after pattern circuit formation worsen.

The object of this invention is to provide an adhesive composition for semiconductor device capable of solving at least one problem of the above-mentioned prior art.

Another object of this invention is to provide an adhesive composition for semiconductor device capable of achieving at least one of increasing modulus of the adhesive layer in room temperature to 100°C and prevention of decreases of adhesive strength to the metal copper foil in room temperature, soldering heat resistance and flexibility of FPC material.

Still another object of this invention is to provide an adhesive composition for semiconductor devices which have a good flexural property under high temperature environments, have all of high adhesive strength in room temperature, high soldering heat resistance and high flexibility, and, furthermore, is excellent in electrical property.

Still another object of this invention is to provide an adhesive sheet, a copper-clad polyimide film and a cover lay film employing the above-mentioned adhesive composition for semiconductor devices.

According to this invention, it is provided that an adhesive composition for semiconductor devices characterized in containing an epoxy resin, phenoxy resin and a hardener, and in that a part or all of said epoxy resin contains at least one type of epoxy resin selected from the followings.

(a) a dimer acid modified epoxy resin
(b) a phosphorus containing epoxy resin having an epoxy equivalent of $2 \times 10^3$ to $6 \times 10^3$

According to this invention, a cover lay, an adhesive sheet and a copper-clad polyimide film employing the above-mentioned adhesive composition are further provided.

According to the adhesive composition of this invention, an adhesive composition for semiconductor devices which satisfies, as well as good flexural property under high temperature environment, all of high adhesive strength in room temperature, high soldering heat resistance, high flexibility and good flame retardancy can be satisfied. In addition, the adhesive sheet, the copper-clad polyimide film and the cover lay in which the adhesive composition obtained by this invention is employed are excellent in flexural property at high temperature environment without spoiling the properties as a flexible print board material.

The composition of this invention is an adhesive composition for semiconductor devices excellent in any of flexural property at high temperature, high adhesive strength to copper foil and, as an FPC, high soldering heat resistance, good flexibility and electric insulation property, which have been difficult to be compatible. This invention can achieve these objects.

Best mode for carrying out the invention

(Adhesive composition)

The adhesive composition of this invention contains at least an epoxy resin, a phenoxy resin and a hardener.

Generally speaking, in the adhesive composition in which a phenoxy resin, an epoxy resin and a hardener are mixed, a crosslinked product of a linear polymer chain (flexible structure), formed by crosslinking reaction of the phenoxy resin, with a three-dimensionally hardened product (rigid structure) formed by hardening reaction of the epoxy resin become entangled moderately, and this adhesive composition is effective to achieve a good FPC flexural property under high temperature environments. However, to achieve high flexural properties of the FPC at high temperature by making Tg (glass transition temperature) of the adhesive layer high, to prevent decrease of adhesive strength and to reduce curl of the FPC, it is preferable that a part or all of the above-mentioned epoxy resin contains at least one type of the epoxy resin selected from the followings. It is also preferable that both of the components (a) and (b) are used together

(a) A dimer acid modified epoxy resin
(b) A phosphorus containing epoxy resin having an epoxy equivalent of $2 \times 103$ to $6 \times 10^3$

(Dimer acid modified epoxy resin)

When the dimer acid modified epoxy resin forms an adhesive composition by hardening reaction, a flexible hardened product may easily be formed due to a structural factor of the dimer acid modified portion, and by imparting the elastomeric property to the adhesive layer, a cross contact of the adhesive layer with the copper foil or with the organic insulation film can be improved. Furthermore, by the addition of the dimer acid modified epoxy resin, the flexible component in the adhesive layer increases and even if a high Tg adhesive layer is used, a good dimensional stability

and curl property can be attained together. Moreover, since a high Tg adhesive layer tends to become weak against thermal shock, it may make the soldering heat resistance property which is indispensable for FPC material deteriorates, but a good soldering heat resistance can be attained together by addition of the dimer acid modified epoxy resin.

As for the dimer acid modified epoxy resin used for this invention, as a requirement in a FPC adhesive layer, it is preferable to have at least one dimer acid selected from the following general formulae for attaining high electric insulation in addition to high Tg, high soldering heat resistance, good dimensional stability and high adhesive strength with copper foil with good balance. Here, the above-mentioned dimer acid modified epoxy resin referred to a resin in which at least one carboxyl group in dimer acid structure reacted with a polyfunctional epoxy resin.

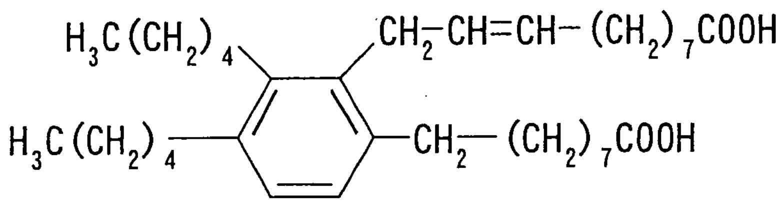

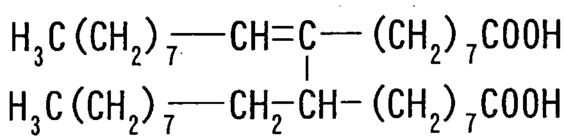

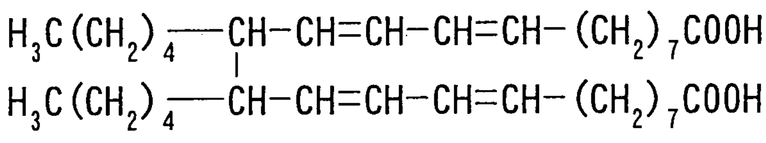

Moreover, as for the dimer acid modified epoxy resin used here, it is preferable to add 2 - 30 weight parts per 100 weight parts of the total adhesive composition, and 2 - 25 weight parts is more preferable. If more than 30 weight parts is added, Tg of the hardened product may fall, and if it is less than 2 weight parts, soldering heat resistance and dimensional stability may fall.

(Phosphorus containing epoxy resin)

It is preferable that the phosphorus containing epoxy resin used in this invention has an epoxy equivalent of 2000 - 6000. By using at least one type of said phosphorus containing epoxy resins, flame retardancy can be achieved with reducing halogen without damaging good flexural property at high temperature of FPC. If the epoxy equivalent is less than 2000, the crosslinking density of the adhesive layer obtained by the reaction with a hardener becomes high and the flexibility of the adhesive layer is spoiled, and soldering heat resistance may fall. If the epoxy equivalent is more than 6000, control of the reaction of phosphorus compound and epoxy resin is difficult owing to arising a gelation, and storage stability may fall. In addition, it is preferable that the amount of the phosphorus containing epoxy resin is 20 - 40 weight parts, more preferably, 25 - 35 weight parts per 100 weight parts of the total adhesive composition. If the amount of the phosphorus containing epoxy resin is less than 20 weight parts, flame retardancy deteriorates, on the other hand, if said amount is more than 40 weight parts, control of the reaction of phosphorus containing epoxy resin with the other epoxy resin is difficult to cause a gelation, etc. and storage stability may fall, and, in addition, when an adhesives solution is prepared, a non-uniform solution is produced due to poor solubility, which may make a coating difficult.

Epoxy equivalent is measured directly by titration at 25° C. For example, 1 g of a resin sample is accurately weighed so that the margin of error is less than 0.1 mg and put into a 100 ml flat-bottom flask. 25 ml of 4/1 mixed liquid of dichloromethane / acetic acid is added to this sample and mixed. Next, 2 g of cetyl trimethyl ammonium bromide (CTAB), four drops of crystal violet pH indicator solution is added. It is titrated speedily with 0.1 M perchloric acid standard solution until the solution color is changed from blue to emerald green. A blank test is carried out similarly and the epoxy equivalent is determined by the following formula.

$$\text{Epoxy equivalent} = 1000 \times m / (V1 - V2) \times M$$

m : weight of sample (g)
V1 : volume of perchloric acid used (ml)
V2 : volume of perchloric acid used in blank test (ml)
M : mol concentration of perchloric acid solution

As for the phosphorus containing epoxy resin used in this invention, there is, for example, a phosphorus containing epoxy resin obtained by reacting an epoxy resin beforehand to the compound obtained by reacting 9,10-dihydro-9-oxa-10-phospha-phenanthrene-10-oxide or its derivative with 1,4-benzoquinone, 1,2-benzoquinone, toluquinone, 1,4-naphtoquinone, etc.

The phosphorus containing epoxy resin may be obtained by, for example, reacting an epoxy resin with a phosphorus compound which has a phenolic hydroxyl group and other aromatic radical on phosphorus atom. What is necessary is just to choose the reaction condition suitably so that a moderate grafted ratio may be obtained and a gelation may not take place. For example, there is a method in which the above-mentioned raw materials react at 20 - 200° C under presence of a tertiary amine type catalyst such as benzyldimethylamine.

In this invention, the phosphorus, containing epoxy resin used preferably is the resin expressed with the following general formula (2).

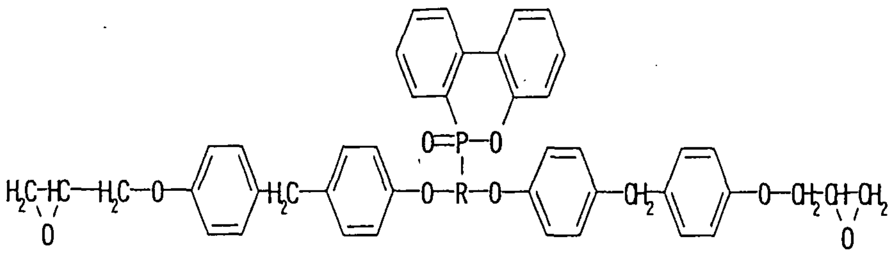
(2)

R is selected from hydrogen atom, alkyl group with 1-12 carbon atoms and the structure shown below.

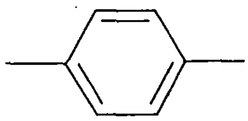
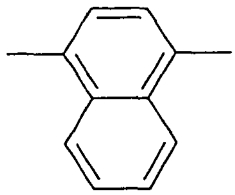

In this invention, it is preferable that the phosphorus content of the phosphorus containing epoxy resin is 4-5%. If the phosphorus content is less than 4%, the amount of flame retarder in the adhesive layer is not sufficient and flame retardancy may fall. If the phosphorus content is more than 5%, control of the reaction of the phosphorus compound with the epoxy resin is difficult and a gelation may take place to worsen storage stability. Moreover, when an adhesives solution is prepared, a non-uniform is produced due to its poor solubility and coating may become difficult. To maintain sufficient flame retardancy together with easy control of the reaction, the phosphorus content of the phosphorus containing epoxy resin is preferably 4.2 - 4.8%.

(Phosphorus content)

The phosphorus content is a value specifically measured by the following method. That is, 25 ml of nitric acids and 10ml of perchloric acid are added to 1 g of sample (phosphorus containing epoxy resin component) and the content are decomposed thermally until it becomes 5-10 ml, and this liquid is diluted with distilled water with a 1000 ml measuring flask. Next, after putting 10 ml of this sample solution into 100 ml measuring flask and adding thereto 10 ml of nitric acids, 10 ml of 0.25% ammonium-vanadate solution and 10 ml of 5% ammonium molybdate solution, the measuring

flask was filled with distilled water to the marked line, shaken sufficiently and left. This colored liquid is put into a quartz cell, and absorbencies of the sample and the phosphorus standard solution in contrast of a blank liquid are measured under the condition of wavelength of 440 nm using a spectrophotometer. Here, the phosphorus standard solution is prepared by putting 10 ml of liquid which is adjusted potassium phosphate to P= 0.1 mg/ml with distilled water into 100 ml measuring flask, and by diluting it with distilled water. The phosphorus content (weight%) is determined by the following formula based on the measurement result of the absorbance.

Phosphorus content (%) = absorbance of sample / absorbance of phosphorus standard solution / sample (g).

(Other components)

In the adhesive resin composition for semiconductor devices of this invention, it is necessary that a part or all of said epoxy resin contains at least one type of epoxy resin selected from (a) dimer acid modified epoxy resin, (b) phosphorus containing epoxy resin having an epoxy equivalent of $2 \times 10^3$ to $6 \times 10^3$, but, if necessary, said composition may also contain other epoxy resins.

(Other epoxy resins)

The epoxy resins which can be used here are not limited especially as far as they have two or more epoxy groups in 1 molecule, but they are exemplified by diglycidyl ethers such as of bisphenol A, bisphenol F, bisphenol S, resorcinol, dihydroxy naphthalene and dicyclopentadiene diphenol, alicyclic epoxy resins such as epoxidated phenol novolak, epoxidated cresol novolak, epoxidated trisphenylolmethane, epoxidated tetraphenylolethane, bisphenol type epoxy resins, novolak type epoxy resins and brominated derivatives of all of them. Specifically, YD-128 (product of Tohto Kasei Co., Ltd.), "Epikote" 828, "Epikote" 180 (products of Yuka Shell Epoxy K.K), etc. can be exemplified. In case of using this "other epoxy resins", its content is preferably 50% by weight or less, more preferably 40% by weight or less per total weight of the adhesive resin composition.

In the composition of this invention, in order to attain non-halogen flame retardancy, as the "other epoxy resins", an epoxy resin which does not contain a halogen, especially a non-bromine type epoxy resin can be selected.

Moreover, in order to raise the glass transition temperature (Tg), after hardening, of the adhesive composition which contains an epoxy resin, as an epoxy resin which has a bulky substituent, bisphenol type epoxy resins having an aromatic ring such as biphenyl or naphthalene skeleton, or having a condensed multi-ring skeleton thereof may be used.

(Phenoxy resin)

As the phenoxy resins used in this invention, for example, a bisphenol A type phenoxy resin, a bisphenol F type phenoxy resin in which the bisphenol F has no multi-fused ring, a copolymer phenoxy resin of bisphenol A and bisphenol F in which the bisphenol F has a multi-fused ring, or a brominated derivative of all them, or such as a derivative obtained by reacting beforehand a compound which has two or more functional groups capable of reacting with epoxy resin such as phenolic hydroxyl group with the above-mentioned phenoxy resin, can be used. Among these phenoxy resins, in order to achieve high flexural property at high temperature of FPC material and to suppress the fall of adhesive strength of the adhesive layer of FPC material and to reduce curl while making the modulus high, it is preferable to use a phenoxy resin consisting of bisphenol F type homopolymer or a bisphenol A type phenoxy resin. In case where these phenoxy resin consisting of bisphenol F type homopolymer or a bisphenol A type phenoxy resin is used, it is easy to form a more flexible hardened product, and furthermore, since its viscosity is low, excellent in coating property of the adhesives on film surface, and compared with phenoxy resins of other structure, it is hard to burn, and excels also in flame retardancy required for adhesive sheet for semiconductor devices, copper-clad polyimide film, and cover lay film.

In this invention, if needed, there is especially no restriction to use an adhesive composition of a mixed type of bisphenol A type phenoxy resin and bisphenol F type phenoxy resin.

It is preferable that the weight average molecular weight of the bisphenol F type phenoxy resin used here is 50000 or more. In addition, it is preferable, in view of flexural property, adhesiveness and flexibility, that the epoxy equivalent is 1000 or more. Moreover, a phenoxy resin which satisfies both of the above-mentioned weight average molecular weight and epoxy equivalent is more preferable. The epoxy equivalent of the phenoxy resin can be determined by the above-mentioned perchloric acid titration method.

Moreover, for imparting the flame retardancy required for a FPC material and improving flexural property, adhesive property and flexibility of the adhesive layer, it is preferable to use a brominated phenoxy resin. As for the

epoxy equivalent of the brominated phenoxy resin, 2000 or more is preferable. If this epoxy equivalent is less than 2000, a flexibility which is required and sufficient for the adhesive layer cannot be imparted.

The amount of the phenoxy resin used in this invention is preferably 100-500 weight parts per epoxy resin 100 weight parts and more preferably 100-300 weight parts. That is, if it is more than 500 weight parts, a problem that an electrical insulating characteristic deteriorates arises, and if it is less than 100, the flexibility of the adhesive composition after hardening cannot be attained.

(Electric property)

A transmission delay, electrical transmission loss and cross talk of signal in print wiring circuit accompanied with becoming signal transmission fast and frequency of the signal transmission high in electronic devices in recent years are also becoming problems. The transmission delay of signal is proportional to the square root of the relative permittivity of the insulating-layer material with which the print wiring circuit contacts, and the cross talk becomes easy to generate in proportion to the electrostatic capacity of the insulator with which the wiring circuit contacts. And this electrostatic capacity is also proportional to the relative permittivity of the insulating-layer material. Since electrical transmission loss becomes large as a dielectric loss tangent becomes large, it has been demanded that, as the insulating-layer material of the print wiring board, both of the permittivity and the dielectric loss tangent are small. In order to respond to this demand of characteristics, it is preferable to use bisphenol F type phenoxy resin expressed by the general formula (1) since it can suppress water absorbance of the adhesive composition for semiconductor devices low, thereby attains good electrical characteristics.

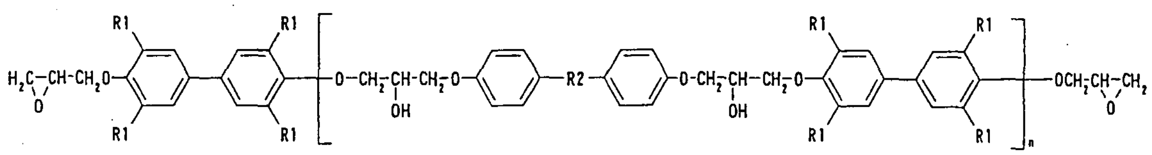

(1)

In the above formula (1), R1 denotes hydrogen or $CH_3$ and each of R1 may be the same or different, R2 denotes any one of $C_6H_{10}$, $C_8H_8$ and $C_{10}H_8$ and each of R2 may be the same or different.

Bisphenol F type phenoxy resin used in this invention preferably satisfies the electrical characteristics of the relative permittivity, e = 4 (1MHz) and the specific dielectric loss tangent, tand = 0.03 (1MHz). A Bisphenol F type phenoxy resin having a relative permittivity, e > 4 (1MHz) and a specific dielectric loss tangent, tand > 0.03 (1MHz) cannot suppress the relative permittivity as an adhesive composition for semiconductor devices low. In addition, it is preferable that the electrical characteristics as an adhesive composition for semiconductor devices have a relative permittivity e = 3.5 (1GHz) and a specific dielectric loss tangent tand = 0.07 (1GHz).

(Preferable combination of phosphorus containing epoxy resin and phenoxy resin)

When the phosphorus containing epoxy resin is used as an epoxy resin, as the phenoxy resin which is used in combination, a bisphenol A type phenoxy resin is preferable which has a good coating property to, such as, polyimide film. In particular, a bisphenol A type phenoxy resin expressed with the general formula (3) is preferable in view of thermal resistance and flexibility of the adhesive layer. In addition, if needed, a mixed type of bisphenol A type phenoxy resin / bisphenol F type phenoxy resin, bisphenol F type phenoxy, etc. may also be used as the adhesive composition.

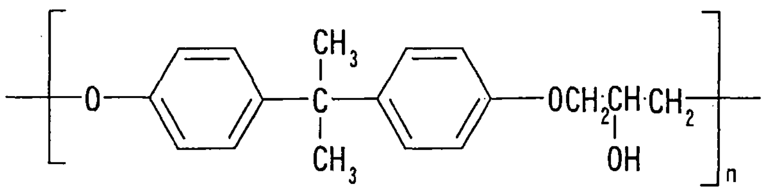

(3)

In the above formula, n denotes the integer of 0 to 10.

(Hardener)

As the hardener used for this invention, there are, for example, aromatic polyamines such as 3,3',5,5'-tetramethyl-4,4'-diamino diphenylmethane, 3,3',5,5'-tetraethyl-4,4'-diamino diphenylmethane, 3,3'-dimethyl-5,5'-diethyl-4,4'-diamino diphenylmethane, 3,3'-dichloro-4,4'-diamino diphenylmethane, 2,2',3,3'-tetrachloro-4,4'-diamino diphenylmethane, 4,4 ' -diamino diphenyl sulfide, 3,3'-diamino benzophenone, 3,3'-diaminodiphenyl sulfone, 4,4'-diaminodiphenyl sulfone, 3,4'-diaminodiphenyl sulfone, 4,4'-diamino benzophenone and 3,4,4'-triamino diphenylsulfone, and phenol novolak resins, etc., but it is not especially limited thereto. In addition, in order to control the hardening rate and moderate flexibility of the adhesive layer, known hardeners such as dicyandiamide or an acid-anhydride type, can also be used. When Tg of the adhesive layer is high, the storage modulus of the adhesive layer in room temperature may become high, and the adhesive strength with the copper foil in FPC material decreases, or a curl occur when a pattern circuit in the copper-clad polyimide film ( CCL), therefore is formed. In order to reduce those problems, it is preferable to use dicyandiamide which is excellent in adhesive property and has a flexible structure.

(Other component)

In the composition of this invention, in addition to the epoxy resin, the hardener, and the phenoxy resin, if needed, a phenol resin, a hardening accelerator, an elastomer, etc. may be added.

For example, as phenol resin, any one of known phenol resins such as novolak type phenol resin, resol type phenol resin can be used. The amount of the phenol resin used is preferably 30 weight % or less based on the total adhesive composition, and more preferably, 20 weight % or less. For example, alkyl substituted phenols such as phenol, cresol, p-t-butyl phenol, nonyl phenol and p-phenyl phenol, cyclic alkyl modified phenols such as terpene and dicyclopentadiene, those having a functional group containing a hetero atom such as nitro group, halogen radical, cyano group and amino group, those having a skeleton such as naphthalene and anthracene, polyfunctional phenols such as bisphenol F, bisphenol A, bisphenol S, resorcinol, pyrogallol, resins with a nitrogen containing phenol such as melamine modified or triazine modified phenols are mentioned.

As the hardening accelerator, an amine complex of boron trifluoride such as boron-trifluoride triethylamine complex, imidazole derivatives such as, 2-alkyl-4-methyl imidazole, 2-phenyl-4-alkyl imidazole, organic acids such as phthalic anhydride and trimellitic anhydride, and dicyandiamide, etc. are mentioned, and these may be used alone or as a mixture of two or more of them. As the amount of the hardening accelerator, 10 weight % or less based on the total adhesive composition is preferable, and 5 weight % or less is more preferable.

In addition, in the composition of this invention, an elastomer component may be included. For example, acrylic rubber, acrylonitrile-butadiene rubber and modified type elastomers such as carboxyl group containing acrylonitrile-butadiene rubber (hereafter, referred to NBR-C), can be added. For example, as examples of NBR-C, a copolymer rubber obtained by copolymerization of acrylonitrile and butadiene in the mole ratio of about 10/90 - 50/50 of which end groups are carboxylated, or a three-component copolymerized rubber of acrylonitrile, butadiene and carboxyl group containing monomer such as acrylic acid or maleic acid, are mentioned. As examples of NBR-C, PNR-1H (trade name, product of Japan Synthetic Rubber Co., Ltd.), "NIPORU" 1072J, "NIPORU" DN612, "NIPORU" DN631 (trade name, product of Nippon Zeon Co., Ltd.), "Hiker" CTBN (trade name, product of BF good rich company), etc. are mentioned. It is preferable that the amount of the elastomer component used is 20 weight % or less based on the total weight of the adhesive composition, more preferably, 10 weight % or less.

Furthermore, in addition to the above-mentioned component, if needed, an inorganic fine particulate agent can be added. It is preferable that the amount of the fine particulate agent to be added is 20 weight % or less based on the total adhesive composition, more preferably, 10 weight % or less. As the inorganic fine particulate agent, metal hydroxides such as an aluminum hydroxide, a magnesium hydroxide, calcium·aluminate hydrate or metallic oxides such as zinc oxide, magnesium oxide, silica, alumina, zirconium dioxide, antimony trioxide, antimony pentoxide, titanium oxide, iron oxide, cobalt oxide, chromium oxide and talc, fine metal particles such as aluminum, gold, silver, nickel and iron, or carbon black or glass are mentioned. Among them, aluminum hydroxide is especially preferable in respect of flame retardancy. They may be used alone or in combination of two or more of them. The mean particle diameter of the inorganic fine particle is preferably 0.2-5 micrometers, when transparency and dispersion stability are taken into consideration. The mean particle diameter means the diameter at which accumulation weight in particle size distribution measured by the laser diffraction scattering method etc. becomes 50% (as for details of the laser diffraction scattering method, if needed, particle diameter distribution measurement of test powder 1 defined in JIS Z. 8901 test powder and test particle (Journal of Powder Technology, No.34) can be referred to).

Moreover, in the composition of this invention, it is not especially restricted to add, in the range which does not spoil the adhesive characteristics, organic or inorganic components such as an anti-oxidant, an ion trapper, a melamine

or its derivative, a compound obtained by reacting 9,10-dihydro-9-oxa-10-phosphaphenanthrene-10-oxide or its derivative with 1,4-benzoquinone, 1,2-benzoquinone, toluquinone, 1,4-naphthoquinone, etc. or phosphorus compounds such as various phosphoric esters, and a silicone compound. It is preferable that the amount of these compounds is 10 weight % or less based on the total weight of the adhesive composition, more preferably 5 weight % or less.

In this invention, in order to impart thermal resistance to the adhesive layer and to improve the rust prevention effect to the metal surface and, in addition, to improve adhesive property with the metal, it is preferable to use an imidazole silane. Moreover, if needed, vinyltriethoxy silane, vinyl tris (2-methoxyethoxy) silane, 3-methacryloxy propyl trimethoxy silane, 3-glycidoxypropyl trimetoxy silane, 2-(3,4-epoxycyclohexyl) ethyltrimethoxy silane, N-2- (aminoethyl)-3-aminopropyl trimethoxy silane, N-phenyl-3-aminopropyl trimethoxy silane, 3-mercaptopropyl trimethoxy silane, 3-chloropropyl trimethoxysilane, etc. may also be used. It is preferable that the amount of these components is 5 weight % or less based on the total weight of the adhesive composition, more preferably, 3 weight % or less.

(Adhesive sheet)

The adhesive sheet of this invention consists of at least one layer of organic insulation film layer and at least one-layer of above-mentioned adhesive layer. As the insulating film preferably used in this invention, a film having a thickness of 5-200 micrometers of plastics such as polyimide, polyester, polyphenylene sulfide, polyether sulfone, polyether ether ketone, aramid, polycarbonate and polyallylate. If needed, a film made by laminating two or more films selected from these films may be used. Moreover, if needed, surface treatment, such as hydrolysis, corona discharge, low-temperature plasma, physical surface roughening and coating treatment to strengthen adhesiveness, can be performed.

(Release film)

Regarding the adhesive sheet for semiconductor devices of this invention, the organic insulation film may be a releasable protection film (release film), and its ingredient is not limited especially if it can release without spoiling the configuration of adhesive layer and the adhesive sheet made thereof. For example, a polyester film or a polyolefin film treated by a coating with a silicone or a fluorine compound and a paper made by laminating them, are mentioned. As an example of the configuration, for example, a releasable polyester protection film (12.5-150 micrometers) / adhesive layer (10-100 micrometers) / a releasable polyester protection film (12.5-150 micrometers) is mentioned.

When the releasing force from the adhesive layer of each protection film layer is set to F1, F2 (F1> F2), (F1-F2) is preferably 5 N/m or more and more preferably 10 N/m or more. When (F1-F2) is smaller than 5 N/m, since it is not sure as to which protection film side is to be released, it is not preferable. Moreover, both of the releasing forces F1 and F2 are 1-200 N/m, preferably 3-150 N/m, more preferably 3-100 N/m. If it is smaller than 1 N/m, the protection film may fall and if it is larger than 200 N/m, releasing may become difficult. Regarding the measurement of the releasing force, if needed, JIS C6481 can be referred to.

The protection film may be colored by a pigment to improve visible property at the time of processing. Since the protection film which is to be released first can be recognized easily by this, misuse is avoidable.

(Cover lay film)

As examples of embodiment of the adhesive sheet for semiconductor devices of this invention, a cover lay film which is used as a protective layer of the pattern circuit formed in the copper-clad polyimide film and a tape with adhesive for tape automated bonding (TAB) can be mentioned. As a main configuration of the cover lay film of this invention, an organic insulation film such as of a polyimide film or an aramid film (12.5-125 micrometers) / an adhesive layer (5-50 micrometers) / a releasable protection film (12.5-125 micrometers) is mentioned.

As main configurations of the copper-clad polyimide film in which an organic insulation film and copper foil are laminated through the preferable adhesive layer of this invention, for example, as a single sided article : copper foil (9-35 micrometers) / adhesive layer (5-20 micrometers) / polyimide film (12.5-125 micrometers), and as a double-sided article: copper foil (9-35 micrometers) /adhesive layer (5-20 micrometers) / polyimide film (12.5-125 micrometers) / adhesive layer (5-20 micrometers) / copper foil (9-35 micrometers) are mentioned. As this copper foil, rolled copper foil, electrodeposited copper foil, specially treated electrodeposited copper foil having similar behavior to the rolled copper foil, unstriated electrolytic copper foil, etc. can generally be used. However, in order to maintain more stable flexural property of copper-clad polyimide film, flexible print wiring board and FPC, rolled copper foil and the specially treated electrodeposited copper foil are suitable.

As an embodiment of the tape with adhesive for tape automated bonding (TAB), such as the product prepared by laminating an adhesive sheet obtained by slitting of (releasable polyester protection film (12.5-150 micrometers) / adhesive layer (5-200 micrometers) / releasable polyester protection film (12.5-150 micrometers)) to a predetermined

standard width (29.7-60.6 mm) on the center of an insulating film of a standard width of 35-70 mm by carrying out a hot calendar roll lamination under conditions of 100-160°C, 10 N/cm and 5 m/min can be mentioned.

(Examples of preferable manufacturing method)

Next, preferable examples of manufacturing method of the adhesive sheet for semiconductor devices, the copper-clad polyimide film, the cover lay film and the tape with adhesive for tape automated bonding (TAB) of this invention are explained.

(Manufacturing example-1: adhesive sheet for semiconductor devices)

A coating liquid in which the adhesive composition of this invention having the above-mentioned constitution is dissolved in a solvent is coated on a polyester film which is treated with a releasing agent on both sides, and the film is dried. As for the thickness of the adhesive layer, it is preferable to apply so that the thickness would be 10-100 micrometers. Drying conditions are 100-200° C and 1-5 minutes. Although the solvent is not especially limited, aromatic type solvents such as toluene, xylene and chlorobenzene, ketone type solvents such as methyl ethyl ketone and methylethyl isobutyl ketone (MIBK), aprotic polar solvents such as dimethylformamide (DMF), dimethylacetamide and N methyl pyrrolidone, and mixtures thereof are preferable.

On the coated and dried adhesive layer, a polyester or polyolefin type protection film which has a still higher releasability is laminated, and the adhesive sheet of this invention is obtained. In order to increase adhesives thickness further, the lamination of the adhesive sheet may be repeated. After the lamination, depending on the case, the degree of hardening may be adjusted by aging, for example, at 40-100° C for about 1-200 hours.

(Manufacturing example-2: copper-clad polyimide film)

An adhesive solution is prepared by dissolving an epoxy resin, a phenoxy resin, a hardener, a hardening accelerator, an inorganic filler, a flame retarder, etc. in a solvent such as MEK (methyl ethyl ketone), MIBK (methyl isobutyl ketone), CB (chlorobenzene) or BA (benzyl alcohol). This adhesive is coated by a coater on a polyimide film ("Kapton" 100 V-P, product of Du Pont-Toray) having a thickness of 25 micrometers so that the dried thickness of the adhesive would be about 10 micrometers, dried at 150° C for 5 minutes, and thereon, a polyester film with a silicone releasing agent having a thickness of 25 micrometers is laminated to thereby obtain an adhesive sheet. Then, the polyester film of the above-mentioned adhesive sheet is stripped, and the adhesive sheet is laminated on the dull surface of 1/2-oz rolled copper foil by 100°C and 2.7 MPa and, in an air oven, heated at 150° C for 5 hours, and a copper-clad polyimide film is produced. When producing a double-sided copper-clad polyimide film, after producing a single-sided adhesive sheet as mentioned above, adhesive is applied again in the same way to the opposite surface to prepare a double-sided adhesive sheet, and a double-sided copper-clad polyimide film can be produced by laminating copper foils to its both surfaces.

(Manufacturing example-3: cover lay film)

Using the adhesives solution prepared by the same way as the above described Manufacturing example-2, this adhesive is coated by a coater on a polyimide film ("Kapton" 100 V-P, product of Du Pont-Toray) having a thickness of 25 micrometers so that the dried thickness of the adhesive would be about 30 micrometers, dried at 150° C for 5 minutes, and thereon, a polyester film with a silicone releasing agent having a thickness of 25 micrometers is laminated to thereby obtain a cover lay film. It is common after that to adjust degree of hardening by aging at 50°C for 20-50 hours so that the amount of bleeding of the adhesive may become proper.

(Manufacturing example-4: tape with adhesive for tape automated bonding (TAB))

An insulating film such as polyimide is coated with the adhesive composition solution and after drying, it is slit to a predetermined width to thereby obtain a tape with adhesive. Alternatively, a tape with adhesive for TAB may also be obtained by, after coating and drying the adhesive composition solution to a protection film such as polyester film treated with a releasing agent, it is slit to obtain a tape with adhesive of a predetermined standard width of 29.7-60.6 mm, and then it is laminated on the center of an insulating film of a standard width of 35-70 mm by carrying out a hot calendar roll lamination under conditions of 100-160°C, 10 N/cm and 5 m/min.

(Application)

The application of the adhesive sheet for semiconductor devices, the cover lay film and the copper-clad polyimide film of this invention is not especially limited. The adhesive sheet for semiconductor devices of this invention, the cover lay film, and the copper-clad polyimide film can be used, not only for a flexible print circuit board, but also for multilayer copper-clad polyimide film circuit board in which plural flexible print circuit boards are laminated using adhesive sheet (s), or a flex rigid circuit board in which a rigid laminate sheet and the flexible print circuit board are laminated into a mixed configuration using adhesive sheet (s), furthermore, a substrate for TAB, various package applications (CSP, BGA), etc. In addition, the manufacturing methods of substrate for TAB and substrate of general circuit board for semi-conductor connection are as follows.

(Manufacturing example of substrate for TAB)

3-35 micrometer electrodeposited or rolled copper foil is laminated to the tape sample with adhesive obtained by Manufacturing example-4 under the condition of 110-180°C, 30 N/cm and 1 m/min. If needed, in an air oven, gradual heat hardening processing is performed at 80-300°C for 1-24 hours, and a substrate for TAB is produced. In this case, a device hole and a solder ball hole may be punched to the tape sample with adhesive before the copper foil lamination.

(Manufacturing example of circuit board for semi-conductor connection)

To the copper-foil surface of the copper-clad polyimide film and the substrate for TAB obtained by the above-mentioned Manufacturing examples-2 and 5, photoresist film formation, etching, resist exfoliation, electrodeposited gold plating, and solder resist film formation are performed in a conventional method and circuit boards for semi-conductor connection are produced.

Examples

Although this invention is explained with reference to the following examples, the interpretation of this invention is not limited to those examples. First, the method for preparing samples used in each evaluation of copper-clad polyimide film and cover lay film, and the evaluation method of each property are described.

(1) The evaluation method of each property

A. Peel strength (Peel)

<Copper-clad polyimide film>

The sample for measurement of the peel strength was prepared by making a copper-clad pattern of 2 mm width by etching a copper-clad polyimide film. The peel strength was measured by peeling off (50 mm/min) the 2 mm width copper foil in 90° C direction using Tensilon (UTM-11-5HR type, product of Orientec). The evaluation was carried out according to JIS-C6481.

<Cover lay>

The cover lay to be evaluated is pressed to the copper foil surface of a copper-clad polyimide film under the condition of 160° C × 30 minute × 4 MPa and a copper-clad polyimide film with cover lay (sample for measuring peel strength of cover lay) is obtained. A cut of 2 mm width is made only into the polyimide and the adhesive layer of the cover lay side, and the peel strength was measured by peeling off (50 mm/min) the 2 mm width polyimide in 90° C direction using Tensilon (UTM-11-5HR type, product of Orientec). The evaluation was carried out according to JIS-C6481.

B. Soldering heat resistance

It was carried out according to JIS-C6481.

<Copper-clad polyimide>

A copper-clad polyimide film is cut into 20 mm square and subjected to conditioning under the atmosphere of 40°C and 90%RH for 24 hours, then it is quickly floated (with the polyimide film upper side) for 30 seconds on the solder

bath of predetermined temperature, and the maximum temperature with no bulging and peeling of the polyimide film was measured. The presence of bulging and peeling were confirmed and decided by visual inspection.

<Cover lay>

The cover lay to be evaluated is pressed to the copper foil surface of a copper-clad polyimide film under the condition of 160° C × 30 minute × 4 MPa and a copper-clad polyimide film with cover lay (sample for measuring soldering heat resistance of cover lay) is obtained. The cover lay is cut into 20 mm square and subjected to conditioning under the atmosphere of 40° C and 90%RH for 24 hours, then it is quickly floated (with the cover lay upper side) for 30 seconds on the solder bath of predetermined temperature, and the maximum temperature with no bulging and peeling of the polyimide film was measured. The presence of bulging and peeling were confirmed and decided by visual inspection.

C. Sliding flexural property

The pattern of the flexural resistance test piece disclosed by JIS-C6471 on a copper-clad polyimide film was produced (in case of a double-sided copper-clad polyimide film, the pattern is formed on one side and on the other side, copper foil is removed entirely by a whole surface etching), and thereon, press bonding of the cover lay film was carried out by 160° C × 30 minutes × 4 MPa, and final test piece was produced. Using this, in high speed flexural tester for FPC (product of Shin-etsu Engineering), it was set to the frequency 1500 cpm, stroke 20 mm, curvature 2.5 mmR and 80°C of environmental temperature the change in resistance of the sample which was installed its cover lay side facing outside was measured, and the count to which resistance goes up to 20% or more from initial value was made into the count of flexure.

D. Curl

Cover-lay: after removing release film from cover lay of 150 mm square, place it on a flat plate so that four corners float, and the maximum distance from the plate is measured.
Copper-clad polyimide: after carrying out overall etching of copper foil from single-sided copper-clad polyimide of 150 mm square and keeping it in an oven at 150° C for 1 hr, it is placed on a flat plate so that four corners float, left in room temperature and the maximum distance from the plate was measured.

E. Fire retardancy

A copper-clad polyimide film and a sample which carried out overall etching of copper foil to the copper-clad polyimide prepared in the evaluation method of the above-mentioned A were prepared. The evaluation was carried out according to UL94 flammability test.

F. Relative permittivity and dielectric loss tangent of semi-conductor adhesive layer

(1) It was measured by the bridge method with LCR meter.

<Measuring device>

· Precision LCR meter HP4284A (product of Agilent Technologies)
· Electrode for measurement SE-70 (product of Ando Electric Co., Ltd)

<Measuring condition>

· Configuration of sample about 20 mm × 20 mm
· Configuration of electrode both of the main electrode and counter-electrode are tin box. 8 mmf is used.
· Pretreatment Ordinary condition adjustment of 22 ± 1°C / 60 ± 5%RH / 90 hours
· Test frequency 1 GHz
· Measuring temperature 22°C / 60%RH.

G. Phosphorus content measuring method

25 ml of nitric acid and 10 ml of perchloric acid are added to 1 g of sample and the content are decomposed thermally until it becomes 5-10 ml, and this liquid is diluted with distilled water with a 1000 ml measuring flask. Next, after putting 10 ml of this sample solution into 100 ml measuring flask and adding thereto 10 ml of nitric acid, 10 ml of 0.25% ammonium-vanadate solution and 10 ml of 5% ammonium molybdate solution, the measuring flask was filled with distilled water to the marked line, shaken sufficiently and left. This coupler is put into a quartz cell, and absorbance of the sample and of the phosphorus standard solution in contrast of a blank liquid is measured under the condition of wavelength of 440 nm using a spectrophotometer. Here, the phosphorus standard solution is prepared by putting 10 ml of liquid which is adjusted potassium phosphate as P= 0.1 mg/ml with distilled water into 100 ml measuring flask, and by diluting it with distilled water. Next, the phosphorus content is determined by the following formula. Phosphorus content (%) = absorbance of sample / absorbance of phosphorus standard solution / sample (g), epoxy equivalent measuring method: sample is dissolved into 4/1 mixed solvent of dichloromethane / acetic acid, and thereto cetyl trimethyl ammonium bromide in an excess amount to the equivalent is added. This solution is titrated, using a crystal violet pH indicator solution, with the 0.1 M perchloric acid standard solution.

Synthetic example 1: Phosphorus containing epoxy resin 1

A phosphorus containing epoxy resin of the structure which is shown below was obtained by reacting 100 weight parts of bisphenol F type epoxy resin having epoxy equivalent 188 with 29 weight parts of 10-(2,7-dihydroxynaphthyl)-9,10-dihydro-9-oxa-10-phosphophenanthrene-10-oxide at 160°C for 5 hours, under existence of benzyl dimethylamine catalyst. The phosphorus content of the obtained resin is 3.8 weight%, and the epoxy equivalent is 2000.

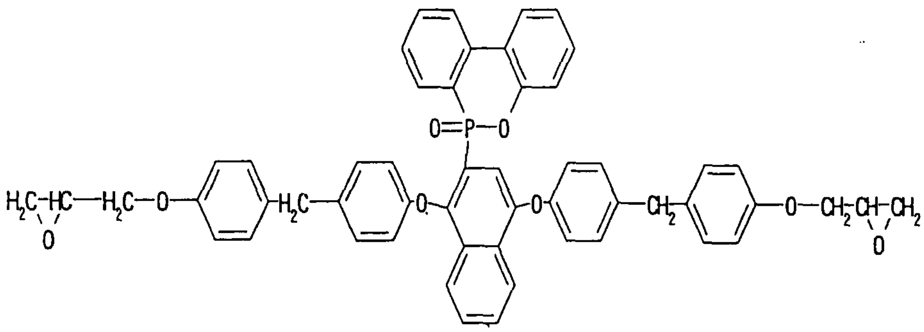

Synthetic example 2 Phosphorus containing epoxy resin 2

A resin having 4.8 weight% of phosphorus content and an epoxy equivalent of 4000 was obtained by reacting an epoxy resin 100 weight parts having epoxy equivalent 215 with 10-(2,7-dihydroxynaphthyl)-9,10-dihydro-9-oxa-10-phosphophenan threne-10-oxide 30 weight parts at 160° C for 5 hours under existence of a catalyst.

Synthetic example 3 Phosphorus containing epoxy resin 3

An epoxy resin having an epoxy equivalent of 1900 and phosphorus content of 4.5 weight% was obtained by reacting 100 weight parts of epoxy resin having an epoxy equivalent of 190 with 10-(2,7-dihydroxynaphthyl)-9,10-dihydro-9-oxa-10-phosphophenan threne-10-oxide 31 weight parts at 160° C for 5 hours under existence of a catalyst.

Synthetic example 4 Phosphorus containing epoxy resin 4

A phosphorus containing epoxy resin was obtained by reacting 100 weight parts of the epoxy resin having epoxy equivalent 350 with 10-(2,7-dihydroxynaphthyl)-9,10-dihydro-9-oxa-10-phosphophenanthrene-10-oxide 40 weight parts at 160°C for 5 hours under existence of a catalyst. The phosphorus content of the obtained resin is 5.2 weight%, and the epoxy equivalent is 6500.

Example 1

Brominated bisphenol A type phenoxy resin (YPB40, product of Tohto Kasei Co., Ltd.), an epoxy resin (Epiclon

830, product of Dainippon Ink Industry,), dicyandiamide (DICY7, hardener produced by Japan Epoxy Resin) and an imidazole type hardening accelerator (EMI24, product of Japan Epoxy Resin) and a dimer acid modified epoxy resin (1600-75X, product of Dainippon Ink Industry) were added in the ratio shown in Table 1 (unit: parts by solid weight) and adjusting to 0.5 Pa·s or less by adding MEK (methyl ethyl ketone), and then, stirred and mixed to thereby obtain an adhesive solution.

This adhesive was applied by a bar coater to a polyimide film ("Kapton" 100 V-P, product of Du Pont-Toray) having a thickness of 25 micrometers so that the dried thickness of the adhesive would be about 10 micrometers, dried at 150°C for 5 minutes, and thereto, a polyester film with a silicone releasing agent having a thickness of 25 micrometers was laminated to thereby obtain an adhesive sheet.

Then, a copper-clad polyimide film was prepared by laminating to this adhesive sheet, 1/2-oz rolling copper foil (JTC foil, product of Japanese Ore Gould Foil) with dull surface inside. On the other hand, the same adhesive is coated by a bar coater on a polyimide film ("Kapton" 100 V-P, product of Du Pont-Toray) having a thickness of 25 micrometers so that the dried thickness of the adhesive would be about 30 micrometers, dried at 150° C for 5 minutes, and thereon, a polyester film with a silicone releasing agent having a thickness of 25 micrometers is laminated to thereby obtain a cover lay film.

Each property of the each film is shown in the following Table 1. In addition, their flexural properties were measured using the copper-clad polyimide film with a cover lay made by forming a predetermined pattern to the above mentioned copper-clad polyimide film and thereafter laminating thereto a cover lay film.

Examples 2-5 and Comparative examples 1 and 2

Copper-clad polyimide films and the cover lay films were produced in the same way as Example 1 using the adhesives prepared by the raw materials and the ratios (unit: parts by solid weight) shown in Tables 1, respectively. Their properties are shown in Tables 1. Regarding the evaluation of flexural properties, they were measured by laminating the copper-clad polyimide film obtained by Example 2 and the cover lay film obtained by Example 2 (that is, the adhesive of the copper-clad polyimide film and the adhesive of the cover lay film are the same). Hereafter, other examples were carried out in the same way.

TABLE 1

| | | | Example | | | | | Comparative example | |
|---|---|---|---|---|---|---|---|---|---|
| | | | 1 | 2 | 3 | 4 | 5 | 1 | 2 |
| Composition | Epoxy resin | | 20 (Epiclon830) | 20 (Epiclon830) | 20 (Ep834) | 20 (Epiclon830) | 9(Epiclon830) 6(Ep5050) | 20 (Epiclon830) | 20 (Epiclon830) |
| | Phenoxy resin | | 35 (YPB40) | 22 (YPB40) | 44 (YPB40) | 64 (YPB40) | 40 (YPB40) | 35 (YPB40) | 40 (YPB40) |
| | Dimer acid modified resin | | 6 (1600-75X) | 6 (1600-75X) | 12 (1600-75X) | 29 (1600-75X) | 6 (1600-75X) | - | - |
| | Hardener | | 1.2 (DICY7) | 1 (DICY7) | 1 (DICY7) | 1 (DICY7) | 1 (DICY7) | 1.2 (DICY7) | 1 (DICY7) |
| | Hardening accelerator | | 0.2 (EMI24) | 0.2 (EMI24) | 0.2 (EMI24) | 0.2 (EMI24) | 0.2 (EMI24) | 0.2 (EMI24) | 0.2 (EMI24) |
| Properties | Peel (N/cm, 25°C) | CCL | 13 | 11 | 10 | 10 | 10 | 5 | 7 |
| | | CL | ≥15 | ≥15 | ≥15 | ≥15 | ≥15 | 3 | 7 |
| | Solder heat resistance (°C) | CCL | 280 | 280 | 280 | 280 | 280 | 220 | 240 |
| | | CL | 270 | 270 | 280 | 270 | 250 | 210 | 240 |
| | Curl (mm) | CCL | 3 | 5 | 4 | 5 | 4 | 32 | 5 |
| | | CL | 2 | 3 | 3 | 3 | 3 | - | - |
| | Electro-resistance (Ω) | | $1 \times 10^{13}$ | $8 \times 10^{12}$ | $2 \times 10^{13}$ | $8 \times 10^{12}$ | $2 \times 10^{13}$ | $1 \times 10^{12}$ | $1 \times 10^{11}$ |
| | Flexural resistance ($\times 10^4$ times, 80°C) | | >5000 | >5000 | >5000 | ≥4000 | >5000 | <2000 | <1000 |

Unit: Solid concentration (weight parts)

In Table 1, the names in the parentheses mean the name of resin used and their details are as follows.

Epiclon 830 : Bisphenol F type epoxy resin (product of Dainippon Ink)
Ep834 : Bisphenol A type epoxy resin (product of Japan Epoxy Resin)
Ep5050 : Brominated bisphenol A type epoxy resin (product of Japan Epoxy Resin)
YPB40 : Brominated bisphenol A type phenoxy resin (product of Tohto Kasei Co., Ltd.)
1600-75X : Dimer acid modified epoxy resin (product of Dainippon Ink Industry)
PNR-1H : Carboxylated NBR (product of Japan Synthetic Rubber)
DICY7 : Dicyandiamide (product of Japan Epoxy Resin)
EMI24 : 2-ethyl-4-methyl imidazole (product of Japan Epoxy Resin).

Example 6

A bisphenol F type phenoxy resin (YL6954BH30 product of Japan Epoxy Resin) and a bisphenol F type epoxy resin (Epiclon 830, product of Dainippon Ink), a hardener (DICY7, dicyandiamide produced by Japan Epoxy Resin), a hardening accelerator (EMI24, product of Japan Epoxy Resin) and a dimer acid modified epoxy resin (1600-75X, product of Dainippon Ink Industry) were added in the ratio shown in Table 2 (unit: parts by solid weight) and adjusted to 1 Pa·s or less by adding MEK, and then, stirred and mixed at 30°C to thereby obtain an adhesive solution. This adhesive was applied by a bar coater to a polyimide film ("Kapton" 100 V-P, product of Du Pont-Toray) having a thickness of 25 micrometers so that the dried thickness of the adhesive would be about 10 micrometers, dried at 150°C for 5 minutes, and thereto, a polyester film with a silicone releasing agent having a thickness of 25 micrometers was laminated to thereby obtain an adhesive sheet. Furthermore, the same process was repeated once again and an adhesive sheet for copper-clad polyimide film having adhesive layer on both sides was obtained. Then, a double-sided copper-clad polyimide film was prepared by laminating to the obtained double-sided adhesive sheet, 1/2-oz rolling copper foils (JTC foil, product of Japanese Ore Gould Foil) with dull surface inside. A polyimide film ("Kapton" 100 V-P product of Du Pont-Toray) having a thickness of 25 micrometers is coated with the same adhesive by a bar coater so that the dried thickness of the adhesive would be about 30 micrometers, dried at 150°C for 5 minutes, and thereon, a polyester film with a silicone releasing agent having a thickness of 25 micrometers is laminated to thereby obtain a cover lay film.
Each property of the each film is shown in the following Table 2. Here, their flexural properties were measured using the copper-clad polyimide film with a cover lay film made by forming a predetermined pattern to the above-mentioned double-sided copper-clad polyimide film and thereafter laminating thereto the cover lay film. The relative permittivity and the dielectric loss tangent of the adhesives layer were measured and found to be fine, that is, relative permittivity = 3.1 and dielectric loss tangent = 0.02.

Examples 7, 8 and 10

Double-sided copper-clad polyimide films and cover lay films were produced in the same way as Example 6 using the raw materials and ratios (unit: parts by solid weight) shown in Table 2. Their properties are shown in Table 2.

Example 9

A bisphenol F type phenoxy resin (YL6954BH30 product of Japan Epoxy Resin) and a bisphenol F type epoxy resin (Epiclon 830, product of Dainippon Ink), a hardener (DICY7, dicyandiamide produced by Japan Epoxy Resin), a hardening accelerator (EMI24, product of Japan Epoxy Resin) and a dimer acid modified epoxy resin (1600-75X, product of Dainippon Ink Industry) were added in the ratio shown in Table 2 (unit: parts by solid weight) and adjusted to 1 Pa·s or less by adding MEK, and then, stirred and mixed at 30°C to thereby obtain an adhesive solution. This adhesive was applied by a bar coater to a polyimide film ("Kapton" 100 V-P, product of Du Pont-Toray) having a thickness of 25 micrometers so that the dried thickness of the adhesive would be about 10 micrometers, dried at 150°C for 5 minutes, and thereto, a polyester film with a silicone releasing agent having a thickness of 25 micrometers was laminated to thereby obtain an adhesive sheet. Then, a single-sided copper-clad polyimide film was prepared by laminating to the obtained single-sided adhesive sheet, 1/2-oz rolling copper foils (JTC foil, product of Japanese Ore Gould Foil) with dull surface inside. The same adhesive was coated by a bar coater on a polyimide film ("Kapton" 100 V-P product of Du Pont-Toray) having a thickness of 25 micrometers so that the dried thickness of the adhesive would be about 30 micrometers, dried at 150°C for 5 minutes, and thereon, a polyester film with a silicone releasing agent having a thickness of 25 micrometers is laminated to thereby obtain a cover lay film.
Each property is shown in Table 2. Here, their flexural properties were measured using the copper-clad polyimide film with a cover lay film made by forming a predetermined pattern to the above mentioned single-sided copper-clad polyimide film and thereafter laminating thereto the cover lay film. The relative permittivity and the dielectric loss tangent

of the adhesive layer were measured and found to be fine, that is, relative permittivity = 3.1 and dielectric loss tangent = 0.02.

Examples 11

A copper-clad polyimide film and a cover lay film were produced in the same way as Example 9 using an adhesive prepared from the raw materials and the ratio (unit: solid content weight parts) shown in Table 2. Their properties are shown in Table 2.

Concerning Examples 6, 7, 10 and 11, the relative permittivity and the dielectric loss tangent of the adhesive layer were measured and found to be good, which satisfy that, relative permittivities e = 3.5 (1GHz) and specific dielectric loss tangents tand = 0.07 (1GHz).

Comparative examples 3 and 4

Double-sided copper-clad polyimide films and cover lay films were produced in the same way as Example 6 using adhesives prepared from the raw materials and the ratios (unit: solid content weight parts) shown in Table 2. Their properties are shown in Table 2.

TABLE 2

| | | | Example | | | | | | Comparative example | |
|---|---|---|---|---|---|---|---|---|---|---|
| | | | 6 | 7 | 8 | 9 | 10 | 11 | 3 | 4 |
| Type (copper-clad) | | | Double-sided | Double-sided | Double-sided | Single-sided | Double-sided | Single-sided | Double-sided | Double-sided |
| Composition | Epoxy resin | | 20 (Epiclon830) | 20 (Epiclon830) | 5 (Ep5050) | 15 (Ep5050) | 20 (Ep834) | 20 (Ep834) | 20 (153-60T) | 20 (Ep5050) |
| | Phenoxy resin | | 35 (YL6954BH30) | 35 (YL6953BH30) | 35 (E4256H40) | 35 (E4256H40) | 35 (YL6974BH30) | 35 (YL6974BH30) | 40 (EXA-192) | 40 (YP40) |
| | Dimer acid modified resin | | 5 (1600-75X) | 5 (1600-75X) | 5 (1600-75X) | 5 (1600-75X) | 5 (1600-75X) | 5 (1600-75X) | - | - |
| | Hardener | | 1 (DICY7) | 1 (DICY7) | 1 (DICY7) | 1 (DICY7) | 1 (DICY7) | 1 (DICY7) | 1 (DICY7) | 1 (DICY7) |
| | Hardening accelerator | | 0.2 (EMI24) | 0.2 (EMI24) | 0.2 (EMI24) | 0.2 (EMI24) | 0.2 (EMI24) | 0.2 (EMI24) | 0.2 (EMI24) | 0.2 (EMI24) |
| Properties | Peel (N/cm, 25°C) | CCL | 10 | 10 | 11 | 11 | 10 | 10 | 5 | 4 |
| | | CL | ≥15 | 9 | 10 | 10 | 10 | 10 | 3 | 4 |
| | Soldering heat resistance (°C) | CCL | 280 | 240 | 240 | 240 | 240 | 240 | 220 | 210 |
| | | CL | 270 | 240 | 240 | 240 | 240 | 240 | 210 | 210 |
| | Curl (mm) | CCL | 3 | 3 | 4 | 4 | 3 | 3 | 30 | 42 |
| | | CL | 3 | 3 | 2 | 2 | 3 | 3 | 20 | 22 |
| | Electro-resistance (Ω) | | $3 \times 10^{13}$ | $1 \times 10^{13}$ | $3 \times 10^{13}$ | $3 \times 10^{13}$ | $5 \times 10^{13}$ | $5 \times 10^{13}$ | $1 \times 10^{11}$ | $1 \times 10^{11}$ |
| | Flexural resistance ($\times 10^4$ times, 80°C) | | >5000 | ≥1000 | ≥1000 | ≥3000 | ≥1000 | ≥2800 | ≥1000 | ≥1000 |
| | Relative permittivity of adhesive (1 MHz) | | 3.1 | 3.15 | 3.5 | 3.5 | 3.2 | 3.2 | - | - |
| | Relative dielectric loss constant (1 MHz) | | 0.02 | 0.06 | 0.11 | 0.11 | 0.25 | 0.25 | - | - |

Unit: Solid concentration (weight parts)

In Table 2, the names in the parentheses mean the name of resins used and their details are as follows except those above-mentioned.

YL6953BH30: Bisphenol F type phenoxy resin (product of Japan Epoxy Resin, relative permittivity (1MHz) = 3.75, specific dielectric loss tangent (1MHz) = 0.024)
YL6954BH30: Bisphenol F type phenoxy resin (product of Japan Epoxy Resin, relative permittivity (1MHz) = 4, specific dielectric loss tangent (1MHz) = 0.026)
YL6974BH30: Bisphenol F type phenoxy resin (product of Japan Epoxy Resin, relative permittivity (1MHz) = 3.8, specific dielectric loss tangent (1MHz) = 0.025)
E4256H40: Bisphenol F type phenoxy resin (product of Japan Epoxy Resin)
YP-40: Bisphenol A type phenoxy resin (product of Tohto Kasei)
153-60T: Brominated bisphenol A type epoxy resin (product of Dainippon Ink)
EXA-192: Bisphenol F type phenoxy resin (product of Dainippon Ink)

Example 12

A bisphenol A type phenoxy resin (YP-40, product of Tohto Kasei Co., Ltd.), the phosphorus containing epoxy resin 1 obtained in Synthetic example 1, a hardener (DICY-7, dicyandiamide produced by Japan Epoxy Resin) and a hardening accelerator (EMI24, product of Japan Epoxy Resin) were added in the ratio (unit: parts by solid weight) shown in Table 3 and adjusted to 3 Pa·s or less by adding cyclohexanone or benzylalcohol, stirred and mixed at 30°C to thereby obtain an adhesive solution. This adhesive was applied by a bar coater to a polyimide film ("Kapton" 100 V-P, product of Du Pont-Toray) having a thickness of 25 micrometers so that the dried thickness of the adhesive would be about 10 micrometers, dried at 150°C for 5 minutes, and thereto, a polyester film with a silicone releasing agent having a thickness of 25 micrometers was laminated to thereby obtain an adhesive sheet. To a double-sided adhesive sheet for double-sided copper-clad polyimide film obtained by repeating the same procedure, 1/2-oz rolling copper foils (BHY foil, product of Japanese Ore Gould Foil) were laminated with dull surface inside, to thereby obtain a double-sided copper-clad polyimide film. On the other hand, a polyimide film ("Kapton" 100 V-P product of Du Pont-Toray) having a thickness of 25 micrometers is coated with the same adhesive by a bar coater so that the dried thickness of the adhesive would be about 30 micrometers, dried at 150°C for 5 minutes, and thereon, a polyester film with a silicone releasing agent having a thickness of 25 micrometers was laminated to thereby obtain a cover lay film. The flexural property was measured using a sample made by combining both samples. That is, the adhesive present in the copper-clad polyimide film and that present in the cover lay film have the same composition.

Examples 13-17 and Comparative example 5, 6

Copper-clad polyimide films and cover lay films were produced in the same way as Example 12 using adhesives prepared from the raw materials and the ratios (unit: solid content weight parts) shown in Tables 3 and 4. Their properties are shown in Tables 3 and 4.

Example 18

A bisphenol A type phenoxy resin (YP-40, product of Tohto Kasei Co., Ltd.), the phosphorus containing epoxy resin 1 obtained in Synthetic example 1, a hardener (DICY-7, dicyandiamide produced by Japan Epoxy Resin) and a hardening accelerator (EMI24, product of Japan Epoxy Resin) were added in the ratio (unit: parts by solid weight) shown in Table 3 and after adjusting to 3 Pa·s or less by adding cyclohexanone or benzylalcohol, stirred and mixed at 30°C to thereby obtain an adhesive solution. This adhesive was applied by a bar coater to a polyimide film ("Kapton" 100 V-P, product of Du Pont-Toray) having a thickness of 25 micrometers so that the dried thickness of the adhesive would be about 10 micrometers, dried at 150°C for 5 minutes, and thereto, a polyester film with a silicone releasing agent having a thickness of 25 micrometers was laminated to thereby obtain an adhesive sheet.

After that, to this adhesive sheet, 1/2-oz rolling copper foils (BHY foil, product of Japanese Ore Gould Foil) was laminated with dull surface inside, to thereby obtain a single-sided copper-clad polyimide film. On the other hand, a polyimide film ("Kapton" 100 V-P product of Du Pont-Toray) having a thickness of 25 micrometers is coated with the same adhesive by a bar coater so that the dried thickness of the adhesive would be about 30 micrometers, dried at 150°C for 5 minutes, and thereon, a polyester film with a silicone releasing agent having a thickness of 25 micrometers was laminated to thereby obtain a cover lay film. The flexural property was measured using a sample made by combining both samples. That is, the adhesive present in the copper-clad polyimide film and that present in the cover lay film have the same composition.

Comparative example 7

A bisphenol A type phenoxy resin (YP-40, product of Tohto Kasei Co., Ltd.), the phosphorus containing epoxy resin 4 obtained in Synthetic example 4, a hardener (DICY-7, dicyandiamide produced by Japan Epoxy Resin) and a hardening accelerator (EMI24, product of Japan Epoxy Resin) were added in the ratio (unit: parts by solid weight) shown in Table 3 and after adjusting to 3 Pa·s or less by adding cyclohexanone or benzylalcohol, stirred and mixed at 30°C to thereby obtain an adhesive solution. However, the obtained solution was non-uniform and it was impossible to obtain a sample capable of evaluation by coating.

TABLE 3

| | | | Example 12 | Example 13 | Example 14 | Example 15 | Example 16 | Example 17 | Example 18 |
|---|---|---|---|---|---|---|---|---|---|
| Type (copper-clad) | | | Double-sided | Double-sided | Double-sided | Double-sided | Double-sided | Double-sided | Single-sided |
| Composition | Epoxy resin | | 10 (Epiclon830) | 10 (Epiclon830) | 10 (Epiclon830) | 10 (Epiclon830) | 10 (Epiclon830) | 10 (Epiclon830) | 10 (Epiclon830) |
| | Posphorous-containing epoxy resin | Amount/kind | 23 (Phosphorus containing epoxy resin1) | 23 (EXA9744) | 23 (EXA9748 A002) | 23 (EXA9748 A002) | 23 (EXA9748 A002) | 23 (Phosphorus containing epoxy resin2) | 23 (Phosphorus containing epoxy resin2) |
| | | Phosphorus content (%) | 3.8 | 4.3 | 4.5 | 4.5 | 4.5 | 4.8 | 4.8 |
| | | Epoxy equivalent | 2000 | 2000 | 5900 | 5900 | 5900 | 4000 | 4000 |
| | Phenoxy resin | | 48 (E4256H40) | 48 (E4256H40) | 48 (E4256H40) | 48 (E4256H40) | 48 (YP40) | 48 (E4256H40) | 48 (E4256H40) |
| | Hardener | | 1 (DICY7) | 1 (DICY7) | 1 (DICY7) | 1 (DICY7) | 1 (DICY7) | 1 (DICY7) | 1 (DICY7) |
| | Hardening accelerator | | 0.3 (EMI24) | 0.3 (EMI24) | 0.3 (EMI24) | 0.3 (EMI24) | 0.3 (EMI24) | 0.3 (EMI24) | 0.3 (EMI24) |
| | Imidazole silane | | - | - | - | 0.8 (IS-1000) | 0.8 (IS-1000) | - | - |
| Properties | Peel (N/cm, 25°C) | CCL | 9 | 10 | 11 | 12 | 13 | 11 | 11 |
| | | CL | 8.5 | 9 | 11 | 12 | 14 | 12 | 12 |
| | Soldering heat resistance (°C) | CCL | 235 | 240 | 250 | 260 | 270 | 250 | 250 |
| | | CL | 240 | 240 | 250 | 260 | 270 | 255 | 255 |
| | Curl (mm) | CCL | 3 | 3 | 2 | 4 | 3 | 3 | 3 |
| | | CL | 2 | 3 | 2 | 3 | 3 | 2 | 2 |
| | Electro-resistance (Ω) | | $5 \times 10^{13}$ | $8 \times 10^{12}$ | $5 \times 10^{13}$ | $4 \times 10^{13}$ | $4 \times 10^{13}$ | $6 \times 10^{13}$ | $6 \times 10^{13}$ |
| | Flexural resistance ($\times 10^4$ times, 80°C) | | 400 | 600 | 800 | 850 | ≥1000 | 900 | ≥3000 |
| | Flame retardancy | | V-0 | V-0 | V-0 | V-0 | V-0 | V-0 | V-0 |

Unit: Solid concentration (weight parts)

TABLE 4

| | | | Comparative example | | |
|---|---|---|---|---|---|
| | | | 5 | 6 | 7 |
| Type (copper-clad) | | | Double-sided | Double-sided | Double-sided |
| Composition | Epoxy resin | | - | - | - |
| | Phosphorus containing epoxy resin | Amount/kind | 23 (EXA-9710) | 23 (Phosphorus containing epoxy resin3) | 23 (Phosphorus containing epoxy resin4) |
| | | Phosphorus content (%) | 3 | 4.5 | 4.5 |
| | | Epoxy equivalent | 400 | 1900 | 6500 |
| | Phenoxy resin | | 48 (YP40) | 48 (E4256H40) | 48 (YP40) |
| | Hardener | | 1 (DICY7) | 1 (DICY7) | 1 (DICY7) |
| | Hardening accelerator | | 0.3 (EMI24) | 0.3 (EMI24) | 0.3 (EMI24) |
| | Imidazole silane | | - | 0.8 (IS-1000) | - |
| Properties | Peel (N/cm, 25°C) | CCL | 6 | 6 | - |
| | | CL | 6 | 5 | - |
| | Soldering heat resistance (°C) | CCL | 200 | 210 | - |
| | | CL | 200 | 210 | - |
| | Curl (mm) | CCL | - | - | - |
| | | CL | - | - | - |
| | Electro-resistance (Ω) | | $1 \times 10^{11}$ | $1 \times 10^{11}$ | - |
| | Flexural resistance ($\times 10^4$ times, 80°C) | | 20 | 40 | - |
| | Flame retardancy | | × | V-0 | - |

Unit: Solid concentration (weight parts)

In Tables 3 and 4, the names in the parentheses mean the name of resin used and their details are as follows except those above-mentioned.

EXA-9744: phosphorus containing epoxy resin (product of Dainippon Ink)
EXA-9748-A002: phosphorus containing epoxy resin (product of Dainippon Ink)
XA-9710: phosphorus containing epoxy resin (product of Dainippon Ink)
E4256H40: Bisphenol F type phenoxy resin (product of Japan Epoxy Resin)
IS-1000: Imidazole silane (product of Japan Ore Materials)

Industrial applicability

The adhesive composition of this invention can preferably be used for an adhesive sheet such as a copper-clad polyimide film or a cover lay film which constitute flexible print wiring board, or for, such as, an adhesive composition which constitutes a circuit board which carries semiconductor devices, etc.

## Claims

1. An adhesive composition for semiconductor devices **characterized in that** it contains at least an epoxy resin, a phenoxy resin and a hardener and a part or all of said epoxy resin contains at least one type of epoxy resin selected

from the followings.

(a) a dimer acid modified epoxy resin
(b) a phosphorus containing epoxy resin having an epoxy equivalent of 2000-6000.

**2.** An adhesive composition for semiconductor devices according to Claim 1, wherein said epoxy resin contains a dimer acid modified epoxy resin (a).

**3.** An adhesive composition for semiconductor devices according to Claim 1, wherein said epoxy resin contains phosphorus containing epoxy resin (b) having an epoxy equivalent of 2000-6000.

**4.** An adhesive composition for semiconductor devices according to Claim 1, wherein said phenoxy resin at least contains a bisphenol F type phenoxy resin.

**5.** An adhesive composition for semiconductor devices according to Claim 4, wherein said adhesive composition for semiconductor devices contains, as said phenoxy resin, a bisphenol F type phenoxy resin having a weight average molecular weight of $5 \times 10^4$ or more.

**6.** An adhesive composition for semiconductor devices according to Claim 4, wherein said adhesive composition for semiconductor devices contains, as said phenoxy resin, a bisphenol F type phenoxy resin having an epoxy equivalent of 6000 or more.

**7.** An adhesive composition for semiconductor devices according to Claim 4, wherein said adhesive composition for semiconductor devices contains, as said phenoxy resin, a bisphenol F type phenoxy resin represented by the general formula (1).

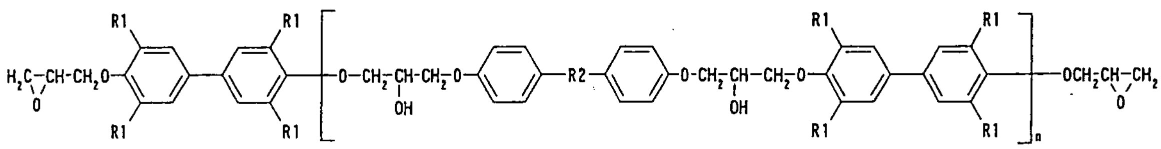

(1)

(In the formula, each R1 may be same or different and represents hydrogen or $CH_3$. Each R2 may be same or different and represents any one of $C_6H_{10}$, $C_8H_8$ and $C_{10}H_8$.)

**8.** An adhesive composition for semiconductor devices according to Claim 1, wherein said dimer acid modified epoxy resin contains at least one dimer acid selected from the following compounds.

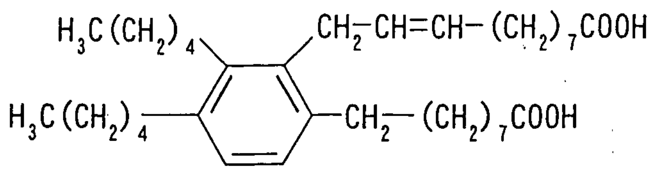

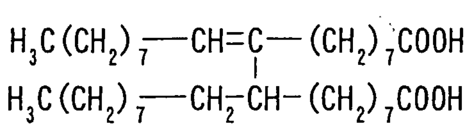

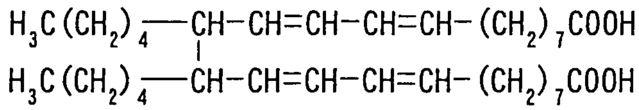

9. An adhesive composition for semiconductor devices according to any one of Claims 1 to 3, wherein said adhesive composition for semiconductor devices contains, as said phenoxy resin, a brominated phenoxy resin.

10. An adhesive composition for semiconductor devices according to any one of Claims 1 to 3, wherein said hardener is dicyandiamide.

11. An adhesive composition for semiconductor devices according to Claim 3, wherein said phosphorus containing epoxy resin is a resin represented by the general formula (2).

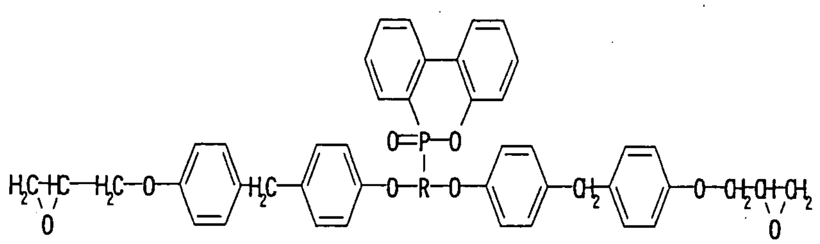

(2)

(In the formula, R is selected from hydrogen atom, an alkyl group with 1 to 12 carbons and the following structures.)

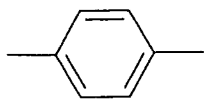

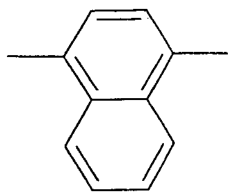

12. An adhesive composition for semiconductor devices according to any one of Claims 1 to 3, further containing an imidazole silane.

13. An adhesive composition for semiconductor devices according to Claim 1 or Claim 11, wherein said phenoxy resin is a bisphenol A type phenoxy resin.

14. An adhesive sheet for semiconductor devices, wherein it is an adhesive sheet containing at least one organic insulation film and an adhesive layer disposed thereon, and said adhesive layer contains adhesive composition for semiconductor devices described in any one of Claims 1 to 13.

15. A cover lay film, wherein it is a cover lay film containing at least one organic insulation film, an adhesive layer disposed thereon and a protective film disposed on the adhesive layer wherein said adhesive layer contains the adhesive composition described in any one of Claims 1 to 13.

16. A copper-clad film, wherein it is a copper-clad film containing at least one organic insulation film, an adhesive layer disposed on said film and a copper foil disposed on the adhesive layer, wherein said adhesive layer contains the adhesive composition described in any one of Claims 1 to 13.

17. A copper-clad film according to Claim 16, wherein it further contains an adhesive layer disposed on the opposite surface of said organic insulation film and a copper foil disposed on the adhesive layer.

**18.** A copper-clad film according to Claims 16 or 17, wherein said organic insulation film is a polyimide film.

## INTERNATIONAL SEARCH REPORT

International application No.
PCT/JP2004/009238

A. CLASSIFICATION OF SUBJECT MATTER
Int.Cl[7] C09J163/00, C09J7/00, B32B15/08

According to International Patent Classification (IPC) or to both national classification and IPC

B. FIELDS SEARCHED

Minimum documentation searched (classification system followed by classification symbols)
Int.Cl[7] C09J163/00, C09J7/00, B32B15/08

Documentation searched other than minimum documentation to the extent that such documents are included in the fields searched

| | | | |
|---|---|---|---|
| Jitsuyo Shinan Koho | 1922-1996 | Toroku Jitsuyo Shinan Koho | 1994-2004 |
| Kokai Jitsuyo Shinan Koho | 1971-2004 | Jitsuyo Shinan Toroku Koho | 1996-2004 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br><br>A | JP 2001-181375 A (Ajinomoto Co., Inc.),<br>03 July, 2001 (03.07.01),<br>Claims<br>& EP 1092739 A1 & US 6403221 A<br>& US 2002-0187353 A1 | 1,3-6,<br>9-18<br>2,7,8 |
| X<br><br>A | JP 2000-277925 A (Sumitomo Bakelite Co., Ltd.),<br>06 October, 2000 (06.10.00),<br>Claims<br>(Family: none) | 1,3-6,<br>9-18<br>2,7,8 |
| X<br><br>A | JP 2000-273429 A (Sumitomo Bakelite Co., Ltd.),<br>03 October, 2000 (03.10.00),<br>Claims; Par. No. [0003]<br>(Family: none) | 1,3-6,<br>9-18<br>2,7,8 |

[X] Further documents are listed in the continuation of Box C.　　[ ] See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 28 July, 2004 (28.07.04) | 17 August, 2004 (17.08.04) |
| Name and mailing address of the ISA/<br>Japanese Patent Office<br><br>Facsimile No. | Authorized officer<br><br><br>Telephone No. |

Form PCT/ISA/210 (second sheet) (January 2004)

INTERNATIONAL SEARCH REPORT

International application No.
PCT/JP2004/009238

C (Continuation). DOCUMENTS CONSIDERED TO BE RELEVANT

| Category* | Citation of document, with indication, where appropriate, of the relevant passages | Relevant to claim No. |
|---|---|---|
| Y<br><br>A | WO 2003/022929 A1 (Hitachi Chemical Co., Ltd.),<br>20 March, 2003 (20.03.03),<br>Claims<br>(Family: none) | 1,3-6,<br>9-18<br>2,7,8 |
| P,X<br><br>P,A | JP 2003-298230 A (Tokai Rubber Industries, Ltd.),<br>17 October, 2003 (17.10.03),<br>Claims<br>(Family: none) | 1,3-6,<br>9-18<br>2,7,8 |

Form PCT/ISA/210 (continuation of second sheet) (January 2004)

**INTERNATIONAL SEARCH REPORT**

International application No.
PCT/JP2004/009238

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:

A matter common to claims 1-18 is the adhesive composition described in claim 1, i.e., "an adhesive composition for semiconductor devices, characterized in that it comprises at least an epoxy resin, a phenoxy resin, and a hardener and that part or all of the epoxy resin comprises at least one epoxy resin selected among the following: (a) epoxy resins modified with a dimer acid and (b) phosphorus-containing epoxy resins having an epoxy equivalent of $2\times10^3$ to $6\times10^3$." However, as a result of an international search, it was found that the common matter neither is novel nor involves an inventive step because it is disclosed in the documents shown in the attached sheet or it has been (continued to extra sheet)

1. ☐ As all required additional search fees were timely paid by the applicant, this international search report covers all searchable claims.

2. ☒ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

☐ The additional search fees were accompanied by the applicant's protest.

☐ No protest accompanied the payment of additional search fees.

Form PCT/ISA/210 (continuation of first sheet (2)) (January 2004)

**INTERNATIONAL SEARCH REPORT**

International application No.
PCT/JP2004/009238

Continuation of Box No.III of continuation of first sheet(2)

easily attainable by persons skilled in the art based on subject matters disclosed in the documents. The matter cannot be regarded as a special technical feature in the meaning of Rule 13.2 of the Regulations under the PCT. Furthermore, any other common matter is not considered to be regarded as a special technical feature. It cannot hence be considered that claims 1-18 are a group of inventions so linked as to form a single general inventive concept.

Form PCT/ISA/210 (extra sheet) (January 2004)